Europäisches Patentamt

European Patent Office

Office européen des brevets

(19)

(11) Veröffentlichungsnummer: **0 259 935 B1**

(12) **EUROPÄISCHE PATENTSCHRIFT**

(45) Veröffentlichungstag der Patentschrift: **11.12.91**

(51) Int. Cl.⁵: **G01R 33/54**, G01R 33/56

(21) Anmeldenummer: **87201725.6**

(22) Anmeldetag: **10.09.87**

(54) **Kernspintomographiverfahren und Kernspintomograph zur Durchführung des Verfahrens.**

(30) Priorität: **12.09.86 DE 3631039**

(43) Veröffentlichungstag der Anmeldung:
**16.03.88 Patentblatt 88/11**

(45) Bekanntmachung des Hinweises auf die
Patenterteilung:
**11.12.91 Patentblatt 91/50**

(84) Benannte Vertragsstaaten:
**DE FR GB NL**

(56) Entgegenhaltungen:
**EP-A- 0 091 008
DE-A- 2 928 551
DE-A- 3 422 688
US-A- 4 115 730
US-A- 4 577 152**

**P. Bösiger: Kernspin-Tomographie für die
medizinische Diagnostic, Stuttgart, Teubner
1985**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

Patentinhaber: **N.V. Philips' Gloeilampenfabrieken
Groenewoudseweg 1
NL-5621 BA Eindhoven(NL)**

(84) Benannte Vertragsstaaten:
**FR GB NL**

(72) Erfinder: **Kuhn, Michael H.
Süntelstrasse 77
W-2000 Hamburg 61(DE)**
Erfinder: **McKinnon, Graeme Colin
Höschgasse 62
CH-8008 Zürich(CH)**

(74) Vertreter: **Hartmann, Heinrich, Dipl.-Ing. et al
Philips Patentverwaltung GmbH Wendenstrasse 35 Postfach 10 51 49
W-2000 Hamburg 1(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Kernspintomographieverfahren gemäß Oberbegriff des Anspruchs 1 sowie auf einen Kernspintomographen zur Durchführung dieses Verfahrens.

Mehrfachschicht-(Multislice-)Verfahren dieser Art sind aus der US-PS 4,577,152 bekannt. Dabei werden mehrere benachbarte Schichten durch zeitlich ineinander verschachtelte Sequenzen angeregt, so daß die Anregung der letzten dieser Schichten erfolgt ist, bevor das erste Spin-Echo-Signal entsteht. Dadurch lassen sich besonders kurze Meßzeiten pro Schicht erzielen, selbst wenn der Abstand zwischen dem ersten Hochfrequenzimpuls, der eine Schicht anregt, und dem Spin-Echo-Signal aus dieser Schicht relativ groß ist.

Bei dem bekannten Verfahren ist während der Spin-Echo-Signale ein magnetisches Gradientenfeld wirksam, das bewirkt, daß die Kernmagnetisierung in den angeregten Schichten dephasiert wird, so daß insbesondere die letzten Spin-Echo-Signale kaum noch detektiert werden können.

Das Problem des Dephasierens der Echosignale durch den Lesegradienten tritt auch bei Verfahren auf, die nur eine Schicht anregen. Zur Lösung dieses Problems ist es aus der EP-A-0 091 008 bekannt, bei einer Spin-Echo-Sequenz das zeitliche Integral über das magnetische Gradientenfeld zwischen dem $90^{\circ}$-Impuls und dem $180^{\circ}$-Hochfrequenzimpuls genauso groß zu machen wie das entsprechende Integral für den Zeitraum nach dem $180^{\circ}$-Impuls bis zum Auftreten des Spin-Echo-Signals.

Aus der DE-OS 33 45 209 und der japanischen Kokai 59-40152 sind weitere Mehrfach-Schichtverfahren bekannt, bei denen mehrere Schichten nacheinander angeregt werden, bevor das erste Echosignal erzeugt wird. Der Nachteil dieser Verfahren besteht darin, daß zuerst das Echosignal aus der zuletzt angeregten Schicht auftritt und daß das Echosignal der zuerst angeregten Schicht als letztes auftritt. Der Abstand zwischen Anregung und Echosignal schwankt also von Schicht zu Schicht, so daß die mit Hilfe dieser Signale erzeugten Schichtbilder unterschiedliche T2-Kontraste aufweisen.

Aufgabe der vorliegenden Erfindung ist es, ein Kernspintomographieverfahren und einen Kernspintomographen zur Durchführung dieses Verfahrens anzugeben, bei dem einerseits die Echosignale in den Schichten in der gleichen Reihenfolge auftreten, in der die Schichten angeregt werden, und bei dem andererseits die Echosignale nicht dephasiert werden.

Ausgehend von einem Verfahren der eingangs genannten Art wird diese Aufgabe erfindungsgemäß durch die im kennzeichnenden Teil des Anspruchs 1 angegebenen Maßnahmen gelöst. Dadurch, daß das magnetische Gradientenfeld nicht nur beim Auftreten der Spin-Echo-Signale eingeschaltet ist, sondern in der angegebenen Weise auch vor und zwischen den weiteren Hochfrequenzimpulsen, wird erreicht, daß beim Auftreten des Spin-Echo-Signals in einer Schicht das zeitliche Integral über das magnetische Gradientenfeld für diese Schicht gerade den Wert Null hat, so daß die Gradientenbedingung erfüllt ist und das Spin-Echo-Signal mit größtmöglicher Amplitude auftritt.

Die Erfindung nutzt die Tatsache aus, daß bei einer Spin-Echo-Sequenz ein vor dem $180^{\circ}$-Hochfrequenzimpuls wirksames magnetisches Gradientenfeld auf das Spin-Echo-Signal den entgegengesetzten Effekt hat wie ein nach dem $180^{\circ}$-Hochfrequenzimpuls wirksames magnetisches Gradientenfeld. Die Einschaltung des magnetischen Gradientenfeldes zwischen den weiteren Hochfrequenzimpulsen wirkt sich also für die Schichten, auf die schon ein $180^{\circ}$-Hochfrequenzimpuls eingewirkt hat, in entgegengesetzter Weise aus wie für die Schichten, bei denen dies nicht der Fall ist. Somit ist die Gradientenbedingung für jede Schicht zu einem anderen Zeitpunkt erfüllt - und zwar zu dem Zeitpunkt, in dem auch das Spin-Echo-Signal auftritt.

An dieser Stelle sei bemerkt, daß, wenn in dieser Anmeldung von dem Auftreten eines Signals oder eines Impulses die Rede ist oder von dem zeitlichen Abstand von Signalen und Impulsen, stets die Mitte dieser Signale bzw. Impulse gemeint ist. Eine Weiterbildung der Erfindung sieht vor, daß die Hochfrequenzimpulse, die die Kernmagnetisierung in jeweils der gleichen Schicht anregen, zumindest annähernd den gleichen zeitlichen Abstand voneinander haben wie die entsprechenden Impulse der anderen Schichten. Dadurch wird erreicht, daß die mit Hilfe dieser Signale erstellten Bilder der verschiedenen Schichten den gleichen T2-Kontrast aufweisen.

In weiterer Ausgestaltung der Erfindung ist vorgesehen, daß nach dem letzten der ersten Hochfrequenzimpulse und vor dem ersten weiteren Hochfrequenzimpuls ein magnetisches Gradientenfeld mit von Zyklus zu Zyklus veränderter Amplitude und/oder Dauer eingeschaltet wird, dessen Gradient jeweils senkrecht zu dem Gradienten des während der Echosignale erzeugten magnetischen Gradientenfeldes verläuft. Dadurch ergibt sich eine für alle angeregten Schichten wirksame Phasenkodierung durch einmaliges Einschalten eines magnetischen Gradientenfeldes.

In weiterer Ausgestaltung der Erfindung ist vorgesehen, daß die ersten Hochfrequenzimpulse die Kernmagnetisierung in der jeweils angeregten Schicht um weniger als $90^{\circ}$ kippen. Dadurch lassen sich besonders kurze Meßzeiten erreichen.

Ein Kernspintomograph zum Durchführen des Verfahrens ist in Anspruch 5 angegeben.

Die Erfindung wird nachstehend anhand der Zeichnung näher erläutert. Es zeigen:

Fig. 1     ein Kernspintomographiegerät, mit dem die Erfindung durchführbar ist,

Fig. 2     ein Blockschaltbild eines solches Gerätes,

Fig. 3     den zeitlichen Verlauf verschiedener Signale bei dem erfindungsgemäßen Verfahren.

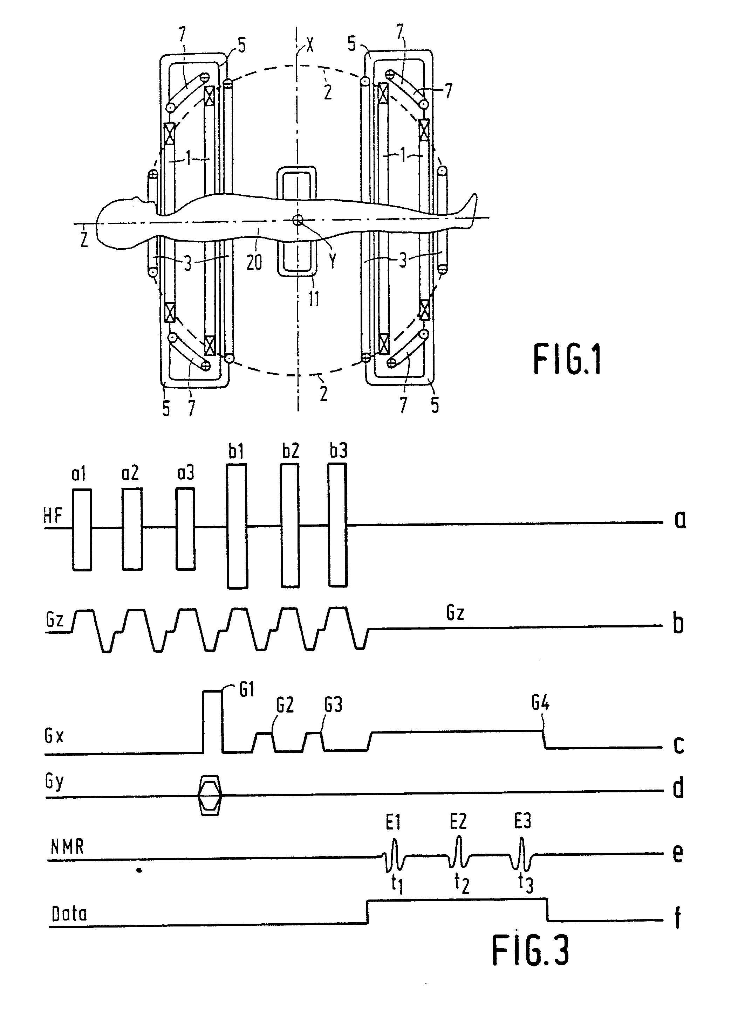

Das in Fig. 1 schematisch dargestellte Kernspintomographiegerät enthält eine aus vier Spulen 1 bestehende Anordnung zur Erzeugung eines homogenen stationären Magnetfeldes. Dieses Feld verläuft in z-Richtung eines kartesischen xyz-Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5, die den gleichen Aufbau wie die Spulen 7 habe können, die jedoch diesen gegenüber um 90° versetzt angeordnet sind. Von diesen vier Spulen sind in Fig. 1 nur zwei dargestellt. Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des kartesischen Koordinatensystems bildet, nur durch das stationäre homogene Magnetfeld der Spulenanordnung I bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an jeden Hochfrequenzimpuls dient die Hochfrequenzspule 11 zum Empfangen von im Untersuchungsbereich erzeugten Kernspin-Resonanzsignalen. An ihrer Stelle kann aber auch eine gesonderte Hochfrequenz-Empfangsspule verwendet werden.

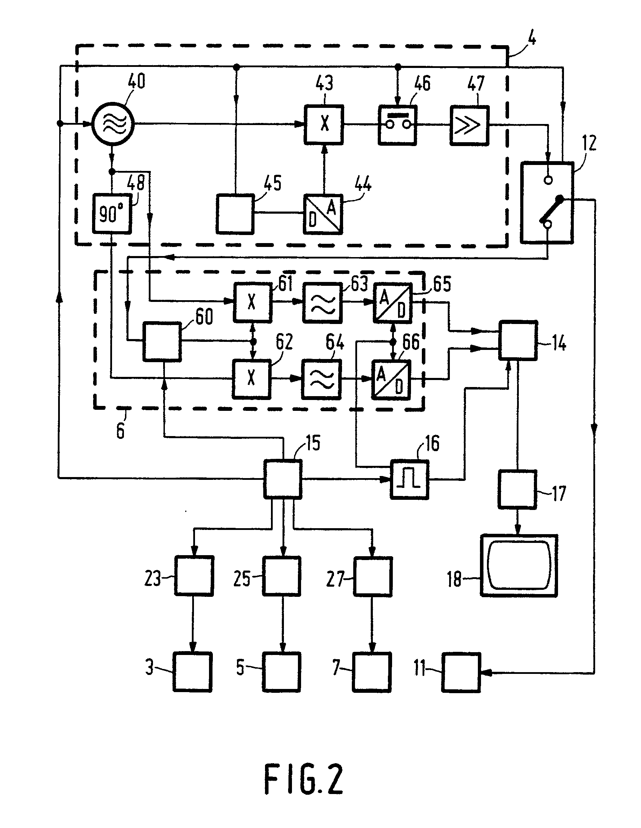

Fig. 2 zeigt ein vereinfachtes Blockschaltbild dieses Kernspin-Tomographiegerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmorfrequenz der anzuregenden Atomkerne bei der von den Spulen I erzeugten Feldstärke aufweist. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beipielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte bzw. Abtastwerte werden einem Rechner 17 zugeführt, der daraus die räumliche Verteilung der Kernmagnetisierung in einer Schicht des Untersuchungsbereiches ermittel und die ermittelte Verteilung an einer geeigneten Wiedergabeeinheit, z.B. einem Monitor 18, ausgibt. - Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

Fig. 3 zeigt den zeitlichen Verlauf verschiedener Signale bei einem Zyklus des erfindungsgemäßen Verfahrens. In jedem Zyklus wird dabei eine der Anzahl der abzubildenden Schichten entsprechende Anzahl erster Hochfrequenzimpulse erzeugt - gemäß Fig. 3a drei Hochfrequenzimpulse a1...a3. Dabei wird der Stromgenerator 23 von der Steuereinheit 15 so gesteuert, daß die magnetischen Gradientenspulen 3 während jedes dieser Impulse ein magnetisches Gradientenfeld Gz erzeugen, dessen Gradient nach jedem Hochfrequenzimpuls seine Richtung um 180° umkehrt und· danach wieder den Wert Null erreicht, so daß zu diesem Zeitpunkt das Integral über das magnetische Gradientenfeld von der Mitte eines Hochfrequenzimpulses an gerade den Wert Null hat (vgl. Fig. 3b).

Die Frequenz des Oszillators 40 und damit der zeitliche Mittelwert der Frequenz der in einem Hochfrequenzimpuls enthaltenen Schwingungen des Hochfrequenz-Magnetfeldes wird von der Steuereinheit 15 dabei von Hochfrequenzimpuls zu Hochfrequenzimpuls geändert. Dies führt dazu, daß durch die drei Hochfrequenzimpulse nacheinander die Kernmagnetisierung in drei gegeneinander versetzten, zur z-Achse senkrechten Schichten angeregt wird.

Nach dem letzten dieser drei ersten Hochfrequenzimpulse folgen drei weitere Hochfrequenzimpulse b1, b2 und b3, die die Kernmagnetisierung jeweils um 180° in der angeregten Schicht kippen. Beim Hochfrequenzimpuls b1 hat die Frequenz des Oszillators 40 den gleichen Wert wie beim Hochfrequenzimpulse a1. Beim Hochfrequenzimpuls b2, der von a2 den gleichen zeitlichen Abstand hat wie b1 von a1, entspricht die Frequenz des Oszillators 40 der Frequenz beim Hochfrequenzimpuls a2. Beim Hochfrequenzimpuls b3 schließlich, der von a3 den gleichen Abstand hat wie a1 von b1, hat die Frequenz den gleichen Wert wie bei dem Hochfrequenzimpuls a3. Während jedes der drei weiteren Hochfrequenzimpulse wird das magnetische Gradientenfeld Gz in gleicher Weise ein- und ausgeschaltet wie bei den Hochfrequenzimpulsen a1...a3, so daß die Hochfrequenzimpulse b1...b3 die Kernmagnetisierungen in den drei zuvor angeregten Schichten um jeweils 180° kippen.

Jede der Schichten wird also durch einen ersten Hochfrequenzimpuls in Verbindung mit einem 180°-Hochfrequenzimpuls angeregt, die das Entstehen eines Spin-Echo-Signals in dieser Schicht bewirken. Die in den drei Schichten erzeugten Spin-Echo-Signale E1, E2 und E3 (vgl. Fig. 3e) treten zu Zeitpunkten t1, t2 und t3 auf, die von den weiteren Hochfrequenzimpulsen b1, b2 bzw. b3 den gleichen Abstand haben wie diese von den ersten Hochfrequenzimpulsen a1, a2 bzw. a3.

Nach dem letzten Hochfrequenzimpuls a3 folgt eine Präparations- oder Kodierungsphase. In diesem Zeitintervall steuert die Steuereinheit 15 den Stromgenerator 25 so, daß die Gradienten-Spulenanordnung 5 ein magnetisches Gradientenfeld Gy erzeugt, dessen Gradient eine von Zyklus zu Zyklus geänderte Größe aufweist (vgl. Fig. 3c).

Die Steuereinheit 15 schaltet den Stromgenerator 27 zur Erzeugung eines magnetischen Gradientenfeldes Gx zwischen dem letzten (a3) der drei ersten Hochfrequenzimpulse und dem ersten der weiteren Hochfrequenzimpulse (b1) ein (G1 -vgl. Fig. 3d), zwischen den Hochfrequenzimpulsen b1...b3 (G2 und G3) sowie nach den drei Hochfrequenzimpulsen (G4) - jeweils mit der gleichen Polarität des Gradienten. Zwischen den weiteren Hochfrequenzimpulsen hat der Gradient G2 bzw. G3 des magnetischen Gradientenfeldes den gleichen Wert wie beim Auftreten der Spin-Echo-Signale (G4). Die Dauer der Einschaltung des magnetischen Gradientenfeldes zwischen den weiteren Hochfrequenzimpulsen ist halb so groß wie der zeitliche Abstand zwischen zwei Hochfrequenzimpulsen (z.B. an a1, a2).

Das magnetische Gradientenfeld Gx vor den weiteren Impulsen hat einen Gradienten G1, der dreimal so groß ist wie zwischen den weiteren Hochfrequenzimpulsen. Die Dauer der Einschaltung des magnetischen Gradientenfeldes ist die gleiche wie zwischen den Hochfrequenzimpulsen. Das magnetische Gradientenfeld G4 nach den drei weiteren Hochfrequenzimpulsen wird in einem zeitlichen Abstand vor dem Auftreten des ersten Echosignals E1 eingeschaltet, der der Hälfte des zeitlichen Abstandes zwischen den Hochfrequenzimpulsen a1 und a2 entspricht und in einem entsprechenden zeitlichen Abstand nach dem Auftreten des dritten Spin-Echo-Signals abgeschaltet.

Nachstehend wird die Auswirkung des beschriebenen zeitlichen Verlaufs des magnetischen Gradientenfeldes Gx auf die Spin-Echo-Signale in den einzelnen Schichten beschrieben:

Für die erste Schicht bewirken G2 und G3 die entgegengesetzte Phasenverschiebung wie G1, weil der $180^\circ$-Hochfrequenzimpuls b1 für diese Schicht zwischen G2 und G3 erzeugt wird. Das zeitliche Integral über G2, G3 und G4 hat zum Zeitpunkt t1 den gleichen Wert wie G1. Deshalb ist für die erste Schicht die Phasenbedingung beim Auftreten des Spin-Echo-Signals dieser Schicht erfüllt.

Für die zweite Schicht hat das magnetische Gradientenfeld G2 in bezug auf die Phasenverschiebung die gleiche Wirkung wie das magnetische Gradientenfeld G1 und die entgegengesetzte Wirkung wie das magnetische Gradientenfeld G3 und G4, weil der $180^\circ$-Hochfrequenzimpuls für diese Schicht zwischen G2 und G3 wirksam ist. Das zeitliche Integral über G1 und G2 entspricht dem zeitlichen Integral über G3 und G4 bis zum Zeitpunkt t2, d.h. die Phasenbedingung für die zweite Schicht ist zum Zeitpunkt t2 erfüllt, in dem das Spin-Echo-Signal für diese Schicht auftritt.

Analog wirken für die dritte Schicht die magnetischen Gradientenfelder G1, G2 und G3 in gleichem Sinne und entgegengesetzt zum magnetischen Gradientenfeld G4, so daß die Gradientenbedingung für die dritte Schicht zum Zeitpunkt t3 erfüllt ist, wenn das Spin-Echo-Signal E3 dieser Schicht auftritt.

Auf diese Weise ist für jede Schicht die Gradientenbedingung gerade dann erfüllt, wenn das Spin-Echo-Signal E1...E3 dieser Schicht auftritt.

Wie sich aus Fig. 3f ergibt, ist der Taktimpulsgenerator 16 während des Auftretens der Spin-Echo-Signale E1...E3 freigegeben. Diese Signale können daher in Digitalwerte umgesetzt und in dem Speicher 14 geladen bzw. im Rechner 17 verarbeitet werden.

Wenn das erfindungsgemäße Verfahren nicht bei drei Schichten, sondern bei n-Schichten angewandt wird, muß der Gradient G1 n mal größer sein als G2 bzw. als G3.

Es ist nicht erforderlich, daß G1, G2 und G3 jeweils gleich lange eingeschaltet sind. Wesentlich ist nur, daß das zeitliche Integral über G1 dreimal bzw. n mal so groß ist wie das zeitliche Integral über G2 bzw. G3 und daß das zeitliche Integral über G4 zwischen zwei Spin-Echo-Signalen (z.B. im Intervall t1-t2) doppelt so groß ist wie das zeitliche Integral über G2 bzw. G3.

Man erkennt sofort, daß sich die gleiche Wirkung ergibt, wenn G1 vergrößert wird und wenn G4 entsprechend früher eingeschaltet wird.

Im Prinzip würde es genügen, wenn das magnetische Gradientenfeld G4 zum Zeitpunkt t1 eingeschaltet und zur Zeit t3 ausgeschaltet würde, so daß nur die zweite Hälfte von E1 und die erste Hälfte von E3 erfaßt werden könnten. In diesem Fall dürfte das zeitliche Integral über G1 nur doppelt (im allgemeinen Fall: n-l mal) so groß sein wie das zeitliche Integral über G2 bzw. G3.

Nach dem Empfang des letzten Spin-Echo-Signals kann der nächste Zyklus gestartet werden usw., wobei lediglich das zeitliche Integral über Gy von Zyklus zu Zyklus variiert wird. Wenn dabei mit dem Beginn des nächsten Zyklus so lange gewartet würde, bis die Längsmagnetisierung in den angeregten Schichten vollständig wieder hergestellt ist (d.h. mindestens einige 100 ms), wäre an sich nicht viel gewonnen - was die Geschwindigkeit der Bilderzeugung betrifft.

Deshalb folgt der Beginn des nächsten Zyklus (bei dem wiederum eine der Anzahl der Schichten entsprechende Anzahl von Hochfrequenzimpulsen a1...a3 bzw. b1...b3 erzeugt wird usw.) in nur geringem Abstand von der Aufnahme des letzten Echosignals. Dabei ist die vor dem ersten Zyklus in z-Richtung verlaufende Kernmagnetisierung im Untersuchungsbereich noch nicht völlig wiederhergestellt. Infolgedessen wären bei dem auf diesen Zyklus folgenden zweiten Zyklus die Echosignale kleiner, und sie würden sich von Zyklus zu Zyklus verringern. Nach etwa 20 bis 30 Zyklen ist jedoch ein stationärer Zustand erreicht, von dem an die Amplitude nicht mehr abnimmt.

Es werden daher nur die Echosignale zur Rekonstruktion verwendet, die nach Erreichen dieses stationären Zustandes erfaßt werden, so daß sich keine Verfälschungen ergeben. Das Signal-Rausch-Verhältnis hängt dabei von dem Flipwinkel (das ist der Winkel, um den die Kernmagnetisierung in der angeregten Schicht durch einen der Hochfrequenzimpulse a1...a3 gekippt wird) des Hochfrequenzimpulses ab. Das günstigste Signal-Rausch-Verhältnis ergibt sich, wenn für den Flipwinkel a jedes der Hochfrequenzimpulse gilt:

$$a = \arccos(\exp(-tr/T1)),$$

wobei T1 die Längs-Relaxationszeit darstellt und tr die Periodendauer einer Sequenz. Im allgemeinen ergibt sich der optimale Kontrast jedoch erst bei größeren Flipwinkeln. In der Regel wird daher mit einem größeren Flipwinkel gearbeitet als sich aus der obigen Formel ergibt, der jedoch deutlich kleiner ist als 90°.

Wenn die Dauer eines Zyklus auf diese Weise verkürzt wird, lassen sich in wenigen Sekunden Bilder verschiedener Schichten erzeugen. Das Auflösungsvermögen und zum Teil auch der Kontrast dieser Bilder sind zwar begrenzt, doch reicht die Bildqualität zumindest für einen groben Überblick über mehrere Schichten aus. Das beschriebene Verfahren wird daher vorteilhaft dazu angewandt, um für ein nachfolgendes Verfahren mit besserer Bildqualität (und wesentlich vergrößertem Zeitaufwand) eine grobe Übersicht zu schaffen.

Vorstehend wurde die Erfindung in Verbindung mit einer zweidimensionalen Fourier-Methode beschrieben. Sie ist jedoch auch bei anderen Kodierungsverfahren anwendbar, z.B. der Rückprojektionsmethode. Dabei entfällt die Phasenkodierung durch Gy und das magnetische Gradientenfeld verläuft dabei proportional zum magnetischen Gradientenfeld Gx in der Fig. 3d. Von Zyklus zu Zyklus wird dabei lediglich die Amplitude der magnetischen Gradientenfelder derart variiert, daß die Summe der Quadrate der Gradienten für alle Zyklen jeweils die gleiche ist.

## Patentansprüche

1. Kernspintomographieverfahren, bei dem mehrere Schichten durch je einen ersten Hochfrequenzimpuls selektiv und nacheinander angeregt werden, wonach in der gleichen Reihenfolge wie zuvor durch weitere selektive Hochfrequenzimpulse die Kernmagnetisierung in diesen Schichten um jeweils 180° gekippt wird, wonach in Anwesenheit eines magnetischen Gradientenfeldes die Spin-Echo-Signale aus den Schichten erfaßt werden,
dadurch gekennzeichnet, daß das magnetische Gradientenfeld (Gx) vor und zwischen den weiteren Hochfrequenzimpulsen (b1...b3) mit einem solchen Gradienten und einer solchen Dauer ein- und ausgeschaltet wird, daß das zeitliche Integral über das magnetische Gradientenfeld (Gx) bis zum Auftreten des eine der Schichten selektiv anregenden weiteren Hochfrequenzimpulses (z.B. b2) den gleichen Wert hat wie das danach bis zum Auftreten des Spin-Echo-Signals (E2) in dieser Schicht sich ergebende zeitliche Integral über das magnetische Gradientenfeld, und zwar dadurch, daß das zeitliche Integral über das magnetische Gradientenfeld (z.B. G2) zwischen zwei weiteren Hochfrequenzimpulsen (z.B. b1, b2) halb so groß ist wie das entsprechende Integral zwischen zwei Spin-Echo-Signalen (z.B. E2, E3) und daß das zeitliche Integral (G1) über das vor den weiteren Hochfrequenzimpulsen (b1...b3) wirksame magnetische Gradientenfeld mindestens n-1 mal größer ist als das entsprechende Integral (z.B. G2) zwischen zwei weiteren Hochfrequenzimpulsen (z.B. b1, b2), wobei n die Zahl der angeregten Schichten ist.

2. Kernspintomographieverfahren nach Anspruch I,
dadurch gekennzeichnet, daß die Hochfrequenzimpulse (z.B. a1, b1) die die Kernmagnetisierung in jeweils der gleichen Schicht anregen, zumindest annähernd den gleichen zeitlichen Abstand voneinander haben wie die entsprechenden Impulse (a2-b2, a3-b3) der anderen Schichten.

3. Kernspintomographieverfahren nach einem der Ansprüche I oder 2,
dadurch gekennzeichnet, daß nach dem letzten der ersten Hochfrequenzimpulse (a3) und vor dem ersten weiteren Hochfrequenzimpuls (b1) ein magnetisches Gradientenfeld (Gy) mit von Zyklus zu Zyklus veränderter Amplitude und/oder Dauer eingeschaltet wird, dessen Gradient jeweils senkrecht zu dem Gradienten des während der Echosignale erzeugten magnetischen Gradientenfeldes (Gx) verläuft.

4. Kernspintomographieverfahren nach einem der Ansprüche I bis 3,
dadurch gekennzeichnet, daß die ersten Hochfrequenzimpulse die Kernmagnetisierung in der jeweils angeregten Schicht um weniger als 90° kippen.

5. Kernspintomograph mit einem Magneten (1) zur Erzeugung eines homogenen stationären Magnetfeldes, einer Hochfrequenzspulenanordnung (11) zur Erzeugung eines hochfrequenten, zum stationären Magnetfeld senkrechten Magnetfeldes, mehreren Gradientenspulenanordnungen (3,5,7) zur Erzeugung von in Richtung des stationären Magnetfeldes verlaufenden Magnetfeldern mit in verschiedenen Richtungen verlaufenden Gradienten, einem Hochfreqenzgenerator (4) zur Speisung der Hochfrequenzspulenanordnung (11) mit Hochfrequenzimpulsen mit vorgebbarer Trägerfrequenz und mit Generatoren (23..25, 27) zur Speisung der Gradientenspulenanordnungen sowie mit einer Steuereinheit (15) zur Steuerung des Hochfrequenzgenerators (4) und der Generatoren (23..27) für die Gradientenspulenanordnungen (3...7), wobei die Steuereinheit so programmiert ist, daß zur selektiven Anregung mehrerer Schichten eine entsprechende Anzahl von ersten Hochfrequenzimpulsen (a1..a3) mit voneinander abweichender Frequenz und anschließend weitere Hochfrequenzimpulse (b1..b3) erzeugt werden, deren Frequenz sich in gleicher Weise von Impuls zu Impuls ändert wie die der ersten Impulse, und die die Kernmagnetisierung in den Schichten um 180° kippen, dadurch gekennzeichnet, daß die Steuereinheit (15) weiterhin so programmiert ist, daß der Generator (27) zur Erzeugung des während der Erfassung der Spin-Echo-Signale wirksamen Gradientenfeldes (Gx) zwischen und nach den weiteren Hochfrequenzimpulsen (b1..b3) derart ein- und ausgeschaltet wird, daß das zeitliche Integral über das magnetische Gradientenfeld (z.B. G2) zwischen zwei weiteren Hochfrequenzimpulsen (z.B. b1, b2) halb so groß ist wie das entsprechende Integral zwischen zwei Spin-Echo-Signalen (z.B. E2, E3), und daß das zeitliche Integral (G1) über das vor den weiteren Hochfrequenzimpulsen wirksame magnetische Gradientenfeld mindestens n-1 mal größer ist als das entsprechende Integral (z.B. G2) zwischen zwei weiteren Hochfrequenzimpulsen (z.B. b1, b2) wobei n die Zahl der angeregten Schichten ist.

**Claims**

1. A nuclear spin tomography method in which a plurality of slices are selectively and successively excited by a respective first rf pulse, after which the nuclear magnetization in the respective slices is rotated through each time 180° in the same sequence as before by further selective rf pulses, after which the spin echo signals from the slices are detected in the presence of a magnetic gradient field, characterized in that the magnetic gradient field (Gx) is switched on and off before and between the further rf pulses (b1 . . .b3) with such a gradient and for such a duration that the time integral over the magnetic gradient field (Gx) until the appearance of the further rf pulse (for example, b2) selectively exciting one of the slices has the same value as the subsequent time integral over the magnetic gradient field until the appearance of the spin echo signal (E2) in the relevant slice because the time integral over the magnetic gradient field (for example, G2) between two further rf pulses (for example, b1, b2) amounts to half the corresponding integral between two spin echo signals (for example, E2, E3) and the time integral (G1) over the magnetic gradient field applied before the further rf pulses (b1 . . .b3) is at least n-1 times greater than the corresponding integral (for example, G2) between two further rf pulses (for example, b1, b2), n being the number of excited slices.

2. A nuclear spin tomography method as claimed in Claim 1, characterized in that the rf pulses (for example, a1, b1) which excite the nuclear magnetization in each time the same slice are separated by at least approximately the same distance in time as the corresponding pulses (a2-b2, a3-b3) of the other slices.

3. A nuclear spin tomography method as claimed in Claim 1 or 2, characterized in that after the last one of the first rf pulses (a3) and before the first one of the further rf pulses (b1) there is applied a magnetic gradient field (Gy) which has an amplitude and/or duration which varies from one cycle to another, its gradient extending each time perpendicularly to the gradient of the gradient magnetic field (Gx) generated during the echo signals.

4. A nuclear spin tomography method as claimed in any one of the Claims 1 to 3, characterized in that the first rf pulses rotate the nuclear magnetization in the respective excited slice through less than 90°.

5. A nuclear spin tomograph, comprising a magnet (1) for generating a uniform, steady magnetic field, an rf coil system (11) for generating an rf magnetic field which extends perpendicularly with respect to the steady magnetic field, several gradient coil systems (3, 5, 7) for generating magnetic fields which extend in the direction of the steady magnetic field and which have gradients which extend in different directions, an rf generator (4) for feeding the rf coil system (11) with rf pulses having a presettable carrier frequency, generators (23...25, 27) for powering the gradient coil systems, and a control unit (15) for controlling the rf generator (4) and the generators (23...27) for the gradient coil systems (3...7), the control unit being programmed so that for the selective excitation of a plurality of slices there are generated a corresponding number of first rf pulses (a1...a3) of mutually different frequency and subsequently further rf pulses (b1...b3) whose frequency varies from one pulse to another in the same way as that of the first pulses and which rotate the nuclear magnetization in the slices through 180°, characterized in that the control unit (15) is also programmed so that the generator (27) for generating the gradient field (Gx) applied during the detection of the spin echo signals is switched on and off between and after the further rf pulses (b1...b3) so that the time integral over the magnetic gradient field (for example, G2) between two further rf pulses (for example, b1, b2) amounts to half the corresponding integral between two spin echo signals (for example, E2, E3) and the time integral (G1) over the magnetic gradient field applied before the further rf pulses is at least n-1 times greater than the corresponding integral (for example, G2) between two further rf pulses (for example, b1, b2), n being the number of excited slices.

**Revendications**

1. Procédé de tomographie à spin nucléaire, dans lequel plusieurs couches sont excitées chacune sélectivement et en succession par une première impulsion de haute fréquence, après quoi la magnétisation nucléaire dans ces couches est basculée de 180° dans le même ordre de succession que précédemment par des impulsions de haute fréquence sélectives suivantes, puis les signaux d'écho de spin des couches sont détectés en présence d'un champ magnétique de gradient, caractérisé en ce que le champ magnétique de gradient (Gx) avant et entre les impulsions de haute fréquence suivantes (b1, ..., b3) est enclenché et déclenché avec un gradient tel et une durée telle que l'intégrale dans le temps sur le champ magnétique de gradient (Gx) jusqu'à l'apparition de l'impulsion de haute fréquence suivante (par exemple b2) excitant sélectivement l'une des couches, ait la même valeur que l'intégrale dans le temps sur le champ magnétique de gradient existant ensuite jusqu'à l'apparition du signal d'écho de spin (E2) dans cette couche, par le fait que l'intégrale dans le temps sur le champ magnétique de gradient (par exemple G2) entre deux impulsions de haute fréquence suivantes (par exemple b1, b2) vaut la moitié de l'intégrale correspondante entre deux signaux d'écho de spin (par exemple E2, E3) et que l'intégrale dans le temps (G1) sur le champ magnétique de gradient actif avant les impulsions de haute fréquence suivantes (b1, ..., b3) est au moins n-1 fois aussi grande que l'intégrale correspondante (par exemple G2) entre deux impulsions de haute fréquence suivantes (b1, b2), n étant le nombre de couches excitées.

2. Procédé de tomographie à spin nucléaire suivant la revendication 1, caractérisé en ce que les impulsions de haute fréquence (par exemple a1, b1) qui excitent chaque fois la magnétisation nucléaire dans la même couche ont entre elles au moins à peu près la même distance dans le temps que les impulsions correspondantes (a2-b2, a3-b3) des autres couches.

3. Procédé de tomographie à spin nucléaire suivant la revendication 1 ou 2, caractérisé en ce qu'après la dernière des premières impulsions de haute fréquence (a3) et avant la première des impulsions de haute fréquence suivantes (b1), est enclenché un champ magnétique de gradient (Gy) dont l'amplitude et/ou la durée sont modifiées d'un cycle à l'autre, dont le gradient est chaque fois perpendiculaire au gradient du champ magnétique de gradient (Gx) produit pendant les signaux d'écho.

4. Procédé de tomographie à spin nucléaire suivant l'une quelconque des revendications 1 à 3, caractérisé en ce que les premières impulsions de haute fréquence font basculer de moins de 90° la magnétisation nucléaire dans la couche excitée en question.

5. Tomographe à spin nucléaire comprenant un aimant (1) pour produire un champ magnétique homogène statique, un montage de bobines de haute fréquence (11) pour créer un champ magnétique de haute fréquence perpendiculaire au champ magnétique statique, plusieurs montages de bobines de gradient (3, 5, 7) pour créer des champs magnétiques s'étendant dans la direction du champ magnétique statique présentant des gradients s'étendant dans des directions différentes, un générateur de haute fréquence (4) pour alimenter le montage de bobines de haute fréquence (11) en impulsions de haute fréquence ayant une fréquence porteuse qui peut être préimposée et des générateurs (23, ..., 25, 27) pour alimenter les montages de bobines de gradient, de même qu'une unité de commande (15) pour la commande du générateur de haute fréquence (4) et des générateurs (23, ..., 27) pour les montages de bobines de gradient (3, ..., 7), l'unité de commande étant programmée de façon que, pour l'excitation sélective de plusieurs couches, soient produits un nombre correspondant de premières impulsions de haute fréquence (a1, ..., a3) de fréquences différentes entre elles et ensuite des impulsions de haute fréquence (b1, ..., b3) suivantes, dont la fréquence se modifie d'une impulsion à l'autre de la même manière que les premières impulsions et qui font basculer de 180° la magnétisation nucléaire dans les couches, caractérisé en ce que l'unité de commande (15) est, en outre, programmée de façon que le générateur (27) pour la création du champ magnétique de gradient (Gx) actif pendant la détection des signaux d'écho de spin soit enclenché et déclenché entre et après les impulsions de haute fréquence suivantes (b1, ..., b3) de façon que l'intégrale dans le temps sur le champ magnétique de gradient (par exemple G2) entre deux impulsions de haute fréquence suivantes (par exemple b1, b2) vaille la moitié de l'intégrale correspondante entre deux signaux d'écho de spin (par exemple E2, E3) et que l'intégrale dans le temps (G1) sur le champ magnétique de gradient actif avant les impulsions de haute fréquence suivantes soit au moins n-1 fois aussi grande que l'intégrale correspondante (par exemple G2) entre deux impulsions de haute fréquence (par exemple b1, b2) suivantes, n étant le nombre de couches excitées.

FIG.1

FIG.3

FIG.2